# EUROPEAN PATENT APPLICATION

(11) **EP 4 726 400 A1**
(43) Date of publication of application: **15.04.2026**
(21) Application number: 24306682.6
(22) Date of filing: 14.10.2024
(51) Int. Cl.: G01R 31/08, G01R 31/12, H02H 5/10

(54) **METHOD AND SYSTEM FOR HEALTH MONITORING OF A LINE PORTION OF A DC ELECTRICAL POWER SUPPLY NETWORK**

(71) Applicant: Airbus Operations (S.A.S.), 31060 Toulouse Cedex 9 (FR)
(72) Inventor: BAUER, Fabian, 31060 TOULOUSE (FR)
(74) Representative: Cabinet Le Guen Maillet

(57) **Abstract**

A method for detecting a failure in a line portion (200A) of a DC electrical power supply network, the line portion comprising, for a given current direction (204A), a single electrical conductor wire or a plurality of electrical conductor wires (201A, 202A) electrically connected together in series via at least one terminal block (203), the method comprising: at a first end (212) of the line portion, injecting a signal; at a second end (214) of the line portion, receiving said signal; and deciding that there is a failure in the line portion, if at least one predetermined difference criterion, between the injected signal and the received signal, is satisfied. Thus, serial electrical discontinuities along the line can easily be detected.

## Description

### TECHNICAL FIELD

The present invention relates to the field of health monitoring of electrical power supply network.

More precisely, the invention relates to a method and a system for health monitoring of a line portion of a Direct Current (DC) electrical power supply network.

The invention applies in particular, but not exclusively, when such health monitoring system is integrated into an aircraft.

### TECHNICAL BACKGROUND

High Voltage Direct Current (HVDC) electrical supply networks (also referred to as "electrical power circuits" or "electrical power system") are going to take a more prominent role in the aircrafts in the future. Historically the voltages used on aircraft have been low (28V DC), however progressively voltages have been increasing over the years. Some aircrafts currently use a 270V DC electrical power system. On future aircraft, such as a hydrogen propelled aircraft, a system operating at up to 1000V DC is envisaged.

With this increase in voltages, the associated risk landscape has also evolved. There are four main risks (failure categories) associated with these HVDC electrical power systems:
1) Arcing between a positive conductive wire and a negative conductive wire comprised in a given power line of a HVDC electrical supply network; the positive and negative conductive wires can be part of a cable, and in this case they are individually insulated and encased together in a sheath of non-conductive material;
2) Arcing between a positive terminal and a negative terminal of a terminal block (also referred to as "connection block", "terminal block connector" or "terminal connector") comprised in a given power line of a HVDC electrical supply network, the positive terminal being used to electrically connect two positive conductive wires together and the negative terminal being used to electrically connect two negative conductive wires together;
3) Arcing due to bad contacts (bad connections) at a positive or negative terminal of a terminal block comprised in a given power line of a HVDC electrical supply network; and
4) Serial-arcing in-line in a positive conductive wire or in a negative conductive wire comprised in a given power line of a HVDC electrical supply network.

As opposed to failures of categories 1) and 2), failures of categories 3) and 4) are more difficult to detect. Indeed, as no short-circuit between the two phases occurs, traditional detection systems, such as circuit breakers, are not useful for detecting failures of categories 3) and 4). Moreover, during serial failures such as serial-arcing (failure of category 4)) and bad connections at a terminal (failure of category 3)), initially there is no notable change in current that the conductive wire (for the failure of category 4)) or the two conductive wires electrically connected by the terminal (for the failure of category 3)) can distribute. However as the failure progresses, the resistance increases before the conductive wire or wires (of a given power line of a HVDC electrical supply network) fully fail. A detection system is therefore necessary which is able to detect a failure in its infancy before it can lead to a full failure of the conductive wire(s) of the power line.

A known detection method (called "fibre optic serial-arcing detection method") uses an optical fibre which is co-routed with the HVDC power line. In case of serial-arcing (failure of category 4)), the failing conductive wire heats which causes a change in the signal transmitted through the optical fibre, which in effect highlights that a failure exists on the conductive wire. The fibre optic serial-arcing detection has promising prospects for serial detection of failure of category 4). However it has some limitations:
- it is not usable for detecting failure of category 3), therefore a different technology may be necessary to detect such failures;
- it requires a fibre optic cable to be co-routed with the HVDC power line, which further complicates its design;
- as it relies on changes in heat, it may also be prone to spurious detection as the aircraft travels through different climatic conditions; and
- the fibre optic cable also comes with its own failure cases which need to be considered.

It is therefore desirable to provide a solution which makes it possible to detect failures of categories 3) and 4).

### SUMMARY OF THE INVENTION

To this end, it is disclosed herein a method for health monitoring of a line portion of a Direct Current electrical power supply network, the line portion comprising, for a given current direction, a single electrical conductor wire or a plurality of electrical conductor wires electrically connected together in series via at least one terminal block, the method comprising:
- at a first end of the line portion, injecting a signal at an injection point or area of the single electrical conductor wire or at an injection point or area of the first electrical conductor wire of the plurality of electrical conductor wires;
- at a second end of the line portion, receiving said signal at a reception point or area of the single electrical conductor wire or at a reception point or area of the last electrical conductor wire of the plurality of electrical conductor wires; and
- raising an alert indicating a failure in the line portion, if at least one predetermined difference criterion, between the injected signal and the received signal, is satisfied.

Thus, the proposed solution makes it possible to easily detect failures of the aforesaid categories 3) and 4), i.e. serial electrical discontinuities along the power line. Moreover, the proposed solution is less intrusive compared to running an optical cable along the power line, as with the known fibre optic serial-arcing detection method.

In a particular embodiment, the line portion is a line portion of a High Voltage Direct Current, HVDC, electrical power supply network.

In a particular embodiment, the failure in the line portion is caused by an electrical discontinuity belonging to the group comprising:
- an arcing due to bad electrical connection(s) at a terminal of the at least one terminal block; and
- a serial arcing in-line in the single electrical conductor wire or in one of the plurality of electrical conductor wires.

In a particular embodiment, the injected signal is a high frequency electrical signal.

In a particular embodiment, injecting the signal and receiving the signal are carried out using a first inductive coupler and a second inductive coupler respectively.

In a particular embodiment, the injected signal conveys a transmitted code, and wherein raising an alert indicating a failure in the line portion comprises:
- decoding the received signal in order to obtain a received code; and
- raising the alert if the received code is different from the transmitted code.

It is further disclosed herein a computer program product comprising instructions causing execution, by a processor, of the health monitoring method above in any one of its embodiments, when said instructions are executed by the processor.

It is further disclosed herein a non-transitory storage medium, storing instructions causing execution, by a processor, of the health monitoring method above in any one of its embodiments, when said instructions are read from the non-transitory storage medium and executed by the processor.

It is further disclosed herein a system for health monitoring of a line portion of a Direct Current electrical power supply network, the line portion comprising, for a given current direction, a single electrical conductor wire or a plurality of electrical conductor wires electrically connected together in series via at least one terminal block, the system comprising a control device comprising electronic circuitry configured for implementing:
- at a first end of the line portion, injecting a signal via a first coupler and at an injection point or area of the single electrical conductor wire or at an injection point or area of the first electrical conductor wire of the plurality of electrical conductor wires;
- at a second end of the line portion, receiving said signal via a second coupler and at a reception point or area of the single electrical conductor wire or at a reception point or area of the last electrical conductor wire of the plurality of electrical conductor wires; and
- raising an alert indicating a failure in the line portion, if at least one predetermined difference criterion, between the injected signal and the received signal, is satisfied.

It is further disclosed herein an aircraft comprising the system above.

It is further disclosed herein a method for maintaining a line portion of a Direct Current electrical power supply network, the method comprising:
- executing the health monitoring method above in any one of its embodiments, to monitor the health of the line portion; and
- if an alert indicating a failure in the line portion is raised, performing at least one maintenance operation on the line portion.

### LIST OF DRAWINGS

The characteristics of the invention mentioned above, as well as others, will appear more clearly on reading the following description of at least one embodiment, said description being made with respect to the accompanying drawings, among which:
- Fig. 1 schematically illustrates, in side view, an aircraft equipped with a system for health monitoring of a line portion of a DC electrical power supply network, in a particular embodiment;
- Fig. 2 schematically illustrates a line portion of a DC electrical power supply network and a system for health monitoring of this line portion, in a particular embodiment;
- Fig. 3 schematically illustrates a flowchart of a method for health monitoring of a line portion of a DC electrical power supply network;
- Fig. 4 schematically illustrates an example of a hardware platform configured for implementing the control device shown in Fig. 2, in a particular embodiment; and
- Fig. 5 schematically illustrates a flowchart of a method for maintaining a line portion of a Direct Current electrical power supply network.

### DETAILED DESCRIPTION OF AT LEAST ONE EMBODIMENT

In the following description, we consider the particular application in which the electrical power supply network whose health is being monitored is integrated into an aircraft. However, the present invention is not limited to the field of aeronautics.

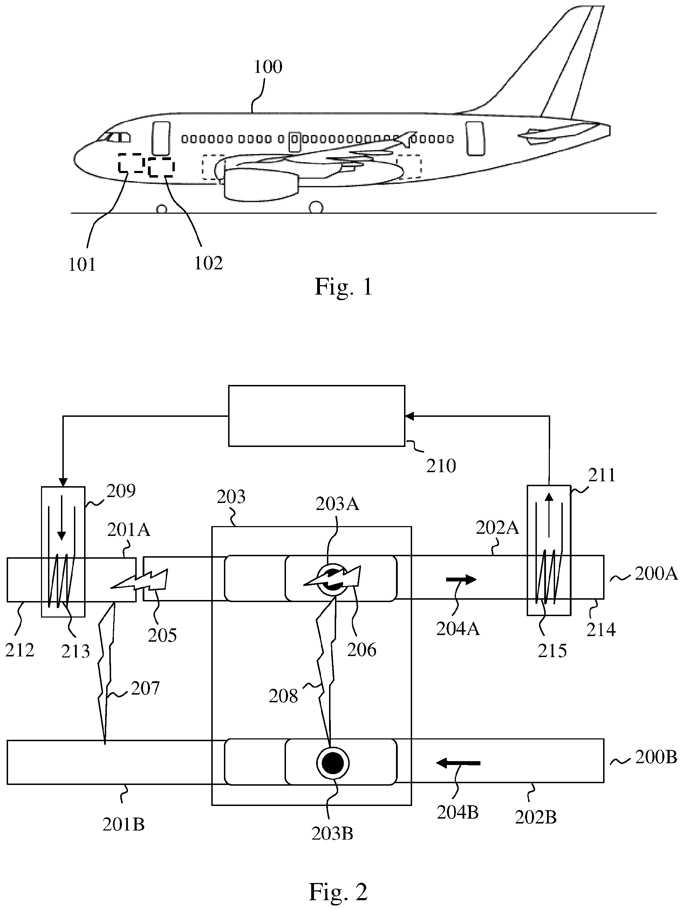

Fig. 1 schematically illustrates, in side view, an aircraft 100. The aircraft 100 comprises a Direct Current (DC) electrical power supply network 101 and a system 102 for health monitoring of a line portion of the DC power supply network 101.

In a particular embodiment, the DC power supply network 101 is a HDVC (High Voltage Direct Current) electrical power supply network.

In a particular embodiment, the aircraft 100 comprises a plurality of health monitoring systems 102, each for health monitoring of a different line portion of the DC power supply network 101. In a particular implementation, some or all of these systems 102 share a common control device (see reference 210 in Fig. 2 disclosed below).

Fig. 2 schematically illustrates a line portion of the DC electrical power supply network 101 and a particular embodiment of the health monitoring system 102.

For a first current direction 204A (from the power source to the electrical devices), a first part 200A of the line portion comprises two electrical conductor wires 201A and 202A (also referred to as "positive wires" or "red wires") electrically connected together in series via a positive terminal 203A of a terminal block 203. In an alternative embodiment, the first part 200A of the line portion comprises a single positive wire. In another alternative embodiment, the first part 200A of the line portion comprises N positive wires, with N ≥ 3, electrically connected together in series by N-1 terminal blocks (two successive positive wires are electrically connected by the positive terminal of one of the terminal blocks).

For a second current direction 204B (return path for the current to the power source), a second part 200B of the line portion comprises two electrical conductor wires 201B and 202B (also referred to as "negative wires" or "black wires") electrically connected together in series via a negative terminal 203B of the terminal block 203. In an alternative embodiment, the second part 200B of the line portion comprises a single negative wire. In another alternative embodiment, the second part 200B of the line portion comprises N negative wires, with N ≥ 3, electrically connected together in series by N-1 terminal blocks (two successive negative wires are electrically connected by the negative terminal of one of the terminal blocks).

For illustrative purposes, four failure examples (corresponding to the aforesaid four failure categories that can affect the line portion), are shown:
1) Arcing 207 between the positive wire 201A and the negative wire 201B, which are comprised respectively in the first part 200A and the second part 200B of the line portion;
2) Arcing 208 between the positive terminal 203A and the negative terminal 203B (of the terminal block 203), which are comprised respectively in the first part 200A and the second part 200B of the line portion;
3) Arcing 206 due to bad contacts (bad connections) at the positive terminal 203 A of the terminal block, which is comprised in the first part 200A of the line portion; and
4) Serial-arcing 205 in-line in the positive wire 201A, which is comprised in the first part 200A of the line portion.

In the embodiment shown in Fig. 2, the health monitoring system 102 comprises a first coupler 209, a second coupler 211 and a control device 210. It applies to the first part 200A of the line portion and allows to detect the arcing 206 and the serial-arcing 205, i.e. failures of the third and fourth categories, noted 3) and 4) respectively.

In an alternative embodiment, two health monitoring systems (similar to that referenced 102) are used, one applies to the first part 200A and the other applies to the second part 200B of the line portion. In a particular implementation of this alternative embodiment, the two health monitoring systems share a common control device (similar to that referenced 210).

The first coupler 209 is positioned at a first end 212 of the first part 200A of the line portion. More precisely, the first coupler 209 is positioned at an end (the one not connected to the positive terminal 203A) of the positive wire 201A, which is the first positive wire of the set of two positive wires 201A and 202A.

The second coupler 211 is positioned at a second end 214 of the first part 200A of the line portion. More precisely, the second coupler 211 is positioned at an end (the one not connected to the positive terminal 203A) of the positive wire 202A, which is the last positive wire of the set of two positive wires 201A and 202A.

In a particular embodiment, the first and second couplers 209 and 211 are inductive couplers. The use of inductive coil means the line portion, and especially the wires, have not to be physically touched. In alternative embodiments, other means of signal injection are used. For example, a simple bit of circuitry is used to tap directly into the wire in order to pass the signal.

The control device 210 is configured for:
- at the first end 212 of the first part 200A of the line portion, injecting a signal, via the first coupler 209, at an injection point or area 213 of the positive wire 201A;
- at the second end 214 of the first part 200A of the line portion, receiving the signal, via the second coupler 211, at a reception point or area 215 of the positive wire 202A; and
- raising an alert indicating a failure in the first part 200A of the line portion, if at least one predetermined difference criterion, between the injected signal and the received signal, is satisfied.

Indeed, electrical signals are very prone to interference caused by failures of aforesaid categories 3) and 4). By inducing an electrical signal on one end of the line portion, and reading this signal on the other end of the line portion, signal continuity can be verified between the injection and ejection points and if an electrical discontinuity occurs, the signal will be impacted.

In a particular embodiment, the injected signal is a high frequency electrical signal.

In a particular embodiment, the control device 210 is configured for computing an amplitude of the difference between the injected signal and the received signal, this amplitude of difference being representative of the size of the line portion failure, therefore providing a means to check for progressive worsening of the failure. One example of an injected signal would be a high frequency radio frequency signal. The high frequency radio frequency signals are quite prone to noise and interference due to serial arcs, as the serial arcs generate electromagnetic interference (EMI) leading to data loss and signal degradation.

In a particular embodiment, the injected signal conveys a transmitted code, and the control device is configured for decoding the received signal, in order to obtain a received code, and raising an alert if the received code is different from the transmitted code. In other words, in this particular embodiment, the at least one predetermined difference criterion (between the injected signal and the received signal) is a difference between the transmitted code and the received code.

In another particular embodiment, the injected signal has a waveform defined by at least one predetermined waveform parameter (e.g. its frequency). The control device is configured for analyzing the received signal, in order to obtain the value of the at least one predetermined waveform parameter for the received signal, and raising an alert if a difference between the value of a given waveform parameter for the injected signal and the value of same waveform parameter for the received signal is higher than a predetermined threshold. In other words, in this other particular embodiment, the at least one predetermined difference criterion (between the injected signal and the received signal) is a difference between values of a same waveform parameter for the injected and received signals. The threshold is for example chosen to prevent a simple parasitic difference (due to the transmission of the signal by the line portion) from triggering an alert.

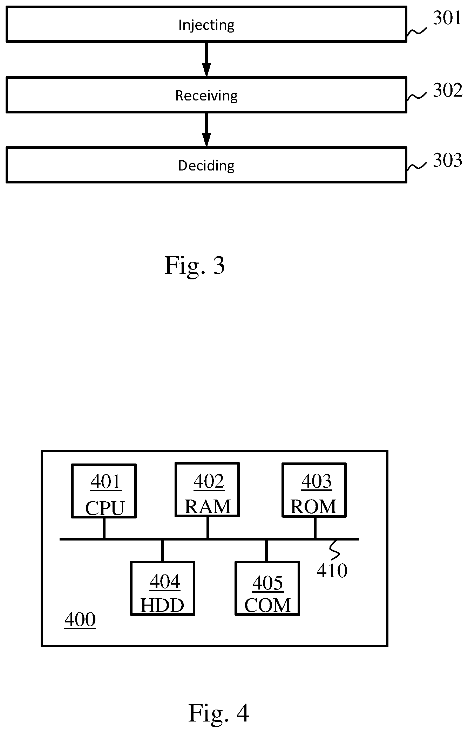

Fig. 3 schematically illustrates a flowchart of a method for health monitoring of a line portion of a DC electrical power supply network. The method of Fig. 3 is for example performed by the control device 210 (which is for example physically arranged according to the hardware platform 400 depicted in Fig. 4).

In a step 401, at the first end 212 of the first part 200A of the line portion, the control device 210 injects a signal, via the first coupler 209, at the injection point or area 213 of the positive wire 201A (first positive wire of the plurality of positive wires).

In a step 402, at the second end 214 of the first part 200A of the line portion, the control device 210 receives the signal, via the second coupler 211, at the reception point or area 215 of the positive wire 202A (last positive wire of the plurality of positive wires).

In a step 403, the control device 21 raises an alert indicating a failure in the first part 200A of the line portion, if at least one predetermined difference criterion, between the injected signal and the received signal, is satisfied.

Fig. 4 schematically illustrates an example of a hardware platform 400, in the form of electronic circuitry, which is configured to implement the control device 210 shown in Fig. 2, in a particular embodiment.

The hardware platform 400 comprises, interconnected by a communication bus 410 : a processor or CPU ("Central Processing Unit") 401 ; a RAM ("Read-Only Memory") 402 ; a ROM ("Read Only Memory") 403 or EEPROM ("Electrically-Erasable Programmable ROM"), such as a Flash memory ; a storage device 404, such as a Hard Disk Drive or a reader device for reading a non-transitory storage medium, such as an SD ("Secure Digital") card reader; and an I/O ("Input/Output") manager 405.

The I/O manager 405 enables the hardware platform 300 to interact with one or more items of equipment of the aircraft 100, such as other items of equipment of the system for detecting a failure in the line portion, in particular the couplers 209 and 211.

CPU 401 is able to execute instructions loaded in RAM 402 from ROM 403, or from an external memory, or from a non-transitory storage medium (such as an SD card), or from a communications network. When the hardware platform 400 is powered up or booted, CPU 401 is able to read instructions from RAM 402 and to execute these instructions. These instructions form a computer program causing implementation, by CPU 401, of all or part of the steps and operations disclosed herein with respect to the control device 210.

All or part of the steps and operations disclosed herein with respect to the control device 210 may be implemented in software form by executing a set of instructions by a programmable machine, such as a processor of DSP ("Digital Signal Processor") type or a microcontroller, or be implemented in hardware form by a chip or chipset, such as an FPGA ("Field Programmable Gate Array") or an ASIC ("Application Specific Integrated Circuit"). In general terms, the hardware platform 400 comprises electronic circuitry configured to implement all or part of the steps and operations disclosed herein with respect to the control device 210.

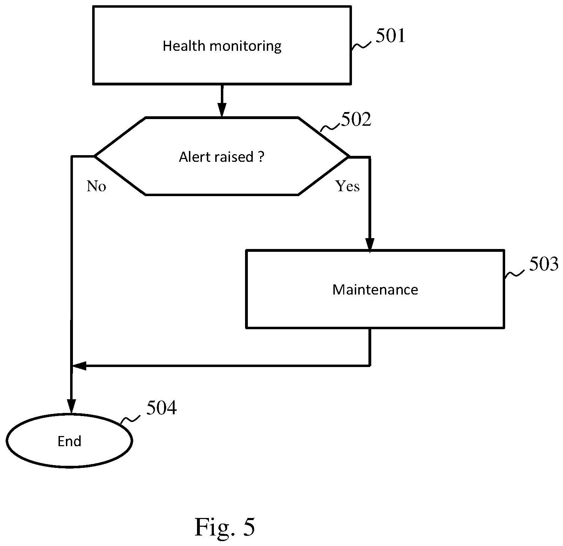

Fig. 5 schematically illustrates a flowchart of a method for maintaining a line portion of a Direct Current electrical power supply network.

In a step 501, the control device 200 executes an algorithm for health monitoring of the line portion, for example in the particular embodiment described above (see the description of Figs. 2 and 3).

If an alert has been triggered at the end of step 501 (result "yes" at the test step 502), at least one maintenance operation, on the line portion, is carried out (step 503), followed by the end step 504. Otherwise (result "no" in the test step 502), the end step 504 is performed directly. In an embodiment, the maintenance operation comprises replacement of the defective line portion.

## Claims

1. A method for health monitoring of a line portion (200A) of a Direct Current electrical power supply network (101), the line portion comprising, for a given current direction (204A), a single electrical conductor wire or a plurality of electrical conductor wires (201A, 202A) electrically connected together in series via at least one terminal block (203), the method comprising:
- at a first end (212) of the line portion (200A), injecting (301) a signal at an injection point or area of the single electrical conductor wire or at an injection point or area (213) of the first electrical conductor wire (201A) of the plurality of electrical conductor wires;
- at a second end (214) of the line portion (200A), receiving (302) said signal at a reception point or area of the single electrical conductor wire or at a reception point or area (215) of the last electrical conductor wire (202A) of the plurality of electrical conductor wires; and
- raising (303) an alert indicating a failure in the line portion, if at least one predetermined difference criterion, between the injected signal and the received signal, is satisfied.

2. The method according to claim 1, wherein the line portion (200A) is a line portion of a High Voltage Direct Current, HVDC, electrical power supply network.

3. The method according to any one of claims 1 and 2, wherein the failure in the line portion is caused by an electrical discontinuity belonging to the group comprising:
- an arcing (206) due to bad electrical connection(s) at a terminal (203A) of the at least one terminal block (203); and
- a serial arcing (205) in-line in the single electrical conductor wire or in one of the plurality of electrical conductor wires (201A, 202A).

4. The method according to any one of claims 1 to 3, wherein the injected signal is a high frequency electrical signal.

5. The method according to any one of claims 1 to 4, wherein injecting the signal and receiving the signal are carried out using a first inductive coupler (209) and a second inductive coupler (211) respectively.

6. The method according to any one of claims 1 to 5, wherein the injected signal conveys a transmitted code, and wherein raising (303) an alert indicating a failure in the line portion comprises:
- decoding the received signal in order to obtain a received code; and
- raising the alert if the received code is different from the transmitted code.

7. A computer program product comprising instructions causing execution, by a processor (401), of the method according to any one of claims 1 to 6, when said instructions are executed by the processor.

8. A non-transitory storage medium (403) storing instructions causing execution, by a processor (401), of the method according to any one of claims 1 to 6, when said instructions are read from the non-transitoray storage medium and executed by the processor.

9. A system (102) for health monitoring of a line portion (200A) of a Direct Current electrical power supply network (101), the line portion comprising, for a given current direction (204A), a single electrical conductor wire or a plurality of electrical conductor wires (201A, 202A) electrically connected together in series via at least one terminal block (203), the system comprising a control device (210) comprising electronic circuitry (400) configured for implementing:
- at a first end (212) of the line portion (200A), injecting a signal via a first coupler (209) and at an injection point or area of the single electrical conductor wire or at an injection point or area (213) of the first electrical conductor wire (201A) of the plurality of electrical conductor wires;
- at a second end (214) of the line portion (200A), receiving said signal via a second coupler (211) and at a reception point or area of the single electrical conductor wire or at a reception point or area (215) of the last electrical conductor wire (202A) of the plurality of electrical conductor wires; and
- raising an alert indicating a failure in the line portion (200A), if at least one predetermined difference criterion, between the injected signal and the received signal, is satisfied.

10. An aircraft (100) comprising the system (102) according to claim 9.

11. A method for maintaining a line portion (200A) of a Direct Current electrical power supply network (101), the method comprising:
- executing (501) the method according to any one of claims 1 to 6, to monitor the health of the line portion; and
- if an alert indicating a failure in the line portion is raised (502), performing (503) at least one maintenance operation on the line portion.
